# EUROPEAN PATENT APPLICATION

(11) **EP 4 071 839 A1**
(43) Date of publication of application: **12.10.2022**
(21) Application number: 20909809.4
(22) Date of filing: 30.12.2020
(51) Int. Cl.: H01L 35/02, H01L 35/34

(54) **THERMOELECTRIC COOLER, MANUFACTURING METHOD FOR THERMOELECTRIC COOLER, AND ELECTRONIC DEVICE**

(30) Priority: 30.12.2019 CN 201911404775
(71) Applicant: Huawei Technologies Co., Ltd., Shenzhen, Guangdong 518129, (CN)
(72) Inventor: YANG, Chengpeng, Shenzhen, Guangdong 518129 (CN); ZHU, Ningjun, Shenzhen, Guangdong 518129 (CN); GUO, Tinghui, Shenzhen, Guangdong 518129 (CN)
(74) Representative: Gill Jennings & Every LLP
(86) International application number: PCT/CN2020/141779
(87) International publication number: WO 2021/136447

(57) **Abstract**

A thermoelectric cooler, a method for preparing a thermoelectric cooler, and an electronic device are provided. The thermoelectric cooler includes two monocrystalline silicon substrates (1) disposed opposite to each other and a plurality of semiconductor thermoelectric particles (3) located between the two monocrystalline silicon substrates (1). An insulation layer (4) is provided on a side that is of a monocrystalline silicon substrate (1) and that faces the semiconductor thermoelectric particles (3). A conductive sheet (2) is provided between the insulation layer (4) and the semiconductor thermoelectric particles (3), and the conductive sheet (2) is electrically connected to the semiconductor thermoelectric particles (3), so that the semiconductor thermoelectric particles (3) form a serial connection circuit. Because the semiconductor thermoelectric particles (3) have a thermoelectric effect, the two monocrystalline silicon substrates (1) of the thermoelectric cooler can be separately cooled and heated. In this application, the monocrystalline silicon substrate (1) is used as a substrate of the thermoelectric cooler. Because costs of the monocrystalline silicon substrate (1) are low, costs of the thermoelectric cooler are low.

## Description

### CROSS-REFERENCE TO RELATED APPLICATIONS

This application claims priority to Chinese Patent Application No. 201911404775.4, filed with the China National Intellectual Property Administration on December 30, 2019 and entitled "THERMOELECTRIC COOLER, METHOD FOR PREPARING THERMOELECTRIC COOLER, AND ELECTRONIC DEVICE", which is incorporated herein by reference in its entirety.

### TECHNICAL FIELD

The present invention relates to the field of electronic technologies, and in particular, to a thermoelectric cooler, a method for preparing a thermoelectric cooler, and an electronic device.

### BACKGROUND

An optical component is an important component in the optical communications field, and internal chips of many optical components are highly sensitive to temperature. To ensure stability of sending or receiving a signal by a chip of the optical component, a thermoelectric cooler (TEC, Thermoelectric Cooler) is generally used to precisely control a temperature of the chip, for example, the temperature of the chip is controlled to be 45 ± 0. 1°C.

As optical components are developing toward low costs and high performance, thermoelectric coolers also face requirements of low costs and high performance. The thermoelectric cooler generally includes two substrates that are disposed opposite to each other, and P-type semiconductor thermoelectric particles and N-type semiconductor thermoelectric particles are sequentially spaced and connected in series between the two substrates. After the P-type semiconductor thermoelectric particles and the N-type semiconductor thermoelectric particles are powered on, cooling or heating may be performed. A substrate of the thermoelectric cooler is an important carrier for performance of the thermoelectric cooler. During thermoelectric cooler design engineering, a thermal conductivity characteristic and an insulation characteristic of the substrate need to be considered when a material of the substrate is selected. Generally, a material of a substrate of a high-performance thermoelectric cooler is insulated aluminum nitride ceramic. A preparing process of the aluminum nitride ceramic is complex and costly. Costs of the substrate account for 20% to 30% of preparation costs of the thermoelectric cooler. Because a conductive structure is disposed on the substrate of the thermoelectric cooler, the substrate is required to be non-conductive. Common insulation materials that can be used for the substrate are mostly ceramic and glass. In addition to aluminum nitride ceramic, common ceramics also include aluminum oxide ceramic. A thermal conductivity coefficient of the aluminum oxide ceramic is about 20 W/mK, and the thermal conductivity coefficient is low.

### SUMMARY

This application provides a thermoelectric cooler, a method for preparing a thermoelectric cooler, and an electronic device, to reduce costs of the thermoelectric cooler while ensuring a heat conductivity characteristic of a substrate of the thermoelectric cooler.

According to a first aspect, a technical solution of this application provides a thermoelectric cooler. The thermoelectric cooler includes two monocrystalline silicon substrates, and the two monocrystalline silicon substrates are stacked opposite to each other. Specifically, the two monocrystalline silicon substrates are disposed in parallel. There are a plurality of semiconductor thermoelectric particles between the two monocrystalline silicon substrates, and the semiconductor thermoelectric particles include P-type semiconductor thermoelectric particles and N-type semiconductor thermoelectric particles that are electrically connected in series with space by using a conductive sheet, to implement a cooling function on one side of the thermoelectric cooler and a heating function on the other side of the thermoelectric cooler. Specifically, an insulation layer is further provided on a side that is of a monocrystalline silicon substrate and that faces the semiconductor thermoelectric particles, a conductive sheet is further provided between the insulation layer and the semiconductor thermoelectric particles, and the conductive sheet is electrically connected to an end part of the semiconductor thermoelectric particles, to implement a serial connection of the semiconductor thermoelectric particles. In this solution, the monocrystalline silicon substrate is used as a substrate of the thermoelectric cooler, and costs of the monocrystalline silicon substrate are low. Therefore, preparation costs of the electronic device can be reduced. In addition, a thermal expansion coefficient of the monocrystalline silicon substrate is low, thermal expansion deformation caused when the monocrystalline silicon substrate is heated is small, and a corresponding warping degree is also low. Therefore, a working effect of the thermoelectric cooler can be improved, a pulling force of the substrate on semiconductor thermoelectric particles can be reduced, reliability of an electrical connection of the semiconductor thermoelectric particles can be improved, and reliability of the thermoelectric cooler can be improved.

When the insulation layer is specifically disposed, a material of the insulation layer is not specifically limited. In a specific embodiment, the insulation layer may be a silicon dioxide film or a silicon nitride film, to simplify a preparation process and costs. In addition, the silicon dioxide film or the silicon nitride film is easy to obtain, and costs are low. In addition, the silicon dioxide film or the silicon nitride film includes silicon, and an adhesive force between the silicon dioxide film or the silicon nitride film and the monocrystalline silicon substrate is good. Therefore, reliability of adhesion between the insulation layer and the monocrystalline silicon substrate can be improved.

A specific process for preparing the insulation layer is not limited. Specifically, when the insulation layer is the silicon dioxide film, the silicon dioxide film may be prepared by using a process such as a thermal oxidation method, a chemical vapor deposition method, or a physical vapor deposition method. A proper process is selected for preparation based on a requirement. If the insulation layer is the silicon nitride film, the insulation layer may be prepared by using a chemical vapor deposition method or a physical vapor deposition method.

A thickness M of the insulation layer may meet: 0.1 µm ≤ M ≤ 1 µm, and the thickness of the insulation layer is at least 0.1 µm. In this way, the insulation layer has an effective insulation effect, and a current is reliably prevented from entering the monocrystalline silicon substrate. Therefore, power supplies can be reduced, resistance can be reduced, and a good working effect of the thermoelectric cooler can be achieved. The thickness of the insulation layer should not exceed 1 µm, and thermal resistance of the insulation layer is low. Therefore, this facilitates temperature conduction through the insulation layer, and improves working efficiency of the thermoelectric cooler can further.

In a specific technical solution, a metallization layer is provided on a side that is of the monocrystalline silicon substrate and that faces away from the semiconductor thermoelectric particles. The metallization layer has good adhesion, and can improve reliability of a connection between the monocrystalline silicon substrate and a structure to be controlled by temperature, and tightness of adhesion between the monocrystalline silicon substrate and the structure to be controlled by temperature.

When the metallization layer is specifically prepared, the metallization layer may be a multi-layer metal structure, and may be specifically the same as a multi-layer metal structure of the conductive sheet, so that the conductive sheet and the metallization layer can be prepared on both sides of the monocrystalline silicon substrate at the same time. Therefore, a preparing process can be simplified, and preparing efficiency can be improved.

A layer structure of the metallization layer is not specifically limited, and may be selected based on a requirement. For example, the metallization layer may include a titanium layer, a copper layer, a nickel layer, and a gold layer that are sequentially disposed in a direction away from the monocrystalline silicon substrate. Alternatively, the metallization layer may include a copper layer, a nickel layer, and a gold layer that are sequentially disposed in a direction away from the monocrystalline silicon substrate. Alternatively, the metallization layer may include a titanium layer, a nickel layer, and a gold layer that are sequentially disposed in a direction away from the monocrystalline silicon substrate. Specifically, the foregoing metal layers may be prepared by using an electroplating process. The copper layer or the titanium layer may improve reliability of fastening the metallization layer and the monocrystalline silicon substrate. The nickel layer is used to prevent electron mobility. The gold layer protects the metal layer between the gold layer and the monocrystalline silicon substrate to reduce a loss caused by oxidation or the like. In addition, the gold layer facilitates adhesion to the structure to be controlled by temperature.

In addition, a manner of implementing a connection between the conductive sheet and the semiconductor thermoelectric particles is not specifically limited. Specifically, a welding manner may be used, and gold-tin alloy (AuSn) solder or tin-antimony alloy (SnSb) solder may be selected. In this solution, effects of electricity conduction and heat conduction are good.

According to a second aspect, this application further provides an electronic device. The electronic device includes a structure controlled by temperature and a thermoelectric cooler. A monocrystalline silicon substrate of the thermoelectric cooler is disposed in contact with the structure controlled by temperature, and is configured to perform temperature control on the structure to be controlled by temperature, so that the structure to be controlled by temperature remains working at a proper temperature. Therefore, a working effect and reliability of the structure to be controlled by temperature can be improved. Because costs of the thermoelectric cooler of the electronic device are low, costs of the electronic device can be reduced.

In a specific technical solution, a specific type of the foregoing structure to be controlled by temperature is not limited. For example, the structure to be controlled by temperature may be a device that is sensitive to temperature, such as an optical component, an electrical component, a laser, or a modulator.

According to a third aspect, this application further provides a method for preparing a thermoelectric cooler. The method includes the following steps: first, cutting a silicon wafer to form a monocrystalline silicon substrate; then, forming an insulation layer on a surface of one side of the monocrystalline silicon substrate; forming a conductive sheet on a surface that is of the insulation layer and that is away from the monocrystalline silicon substrate; and enabling sides of two monocrystalline silicon substrates having conductive sheets to be opposite to each other, and disposing semiconductor thermoelectric particles between the conductive sheets of the two opposite monocrystalline silicon substrates, where the semiconductor thermoelectric particles are connected in series by using the conductive sheets.

In this solution, in the thermoelectric cooler prepared by using the foregoing preparation method, the monocrystalline silicon substrate is used as a substrate of the thermoelectric cooler, and costs of the monocrystalline silicon substrate are low. Therefore, preparation costs of the electronic device can be reduced. In addition, a thermal expansion coefficient of the monocrystalline silicon substrate is low, thermal expansion deformation caused when the monocrystalline silicon substrate is heated is small, and a corresponding warping degree is also low. Therefore, a working effect of the thermoelectric cooler can be improved, a pulling force of the substrate on semiconductor thermoelectric particles can be reduced, reliability of an electrical connection of the semiconductor thermoelectric particles can be improved, and reliability of the thermoelectric cooler can be improved.

When the insulation layer is prepared, a specific material and a preparation process of the insulation layer are not specifically limited. A proper material and a proper preparation process are selected based on an actual material and a preparation condition. In a preparation method, the insulation layer may be a silicon dioxide film, and the silicon dioxide film is prepared by using a thermal oxidation method, a chemical vapor deposition method, or a physical vapor deposition method. Alternatively, the insulation layer may be a silicon nitride film, and the silicon nitride film is prepared by using a chemical vapor deposition method or a physical vapor deposition method.

After the insulation layer is formed on the surface of one side of the monocrystalline silicon substrate, the method further includes: forming a metallization layer on the side that is of the monocrystalline silicon substrate and that faces away from the insulation layer.

A mental layer structure of the metallization layer may be the same as a mental layer structure of the conductive sheet. Two sides of the monocrystalline silicon substrate having the insulation layer are electroplated once to form the metallization layer and the conductive sheet.

To implement the connection between the semiconductor thermoelectric particles and the conductive sheet, a welding manner may be used, that is, the semiconductor thermoelectric particles are welded to the conductive sheet.

### BRIEF DESCRIPTION OF DRAWINGS

FIG. 1 is a schematic diagram of a structure of a thermoelectric cooler according to an embodiment of this application;
FIG. 2 is a schematic diagram of a cross-section structure of a thermoelectric cooler according to an embodiment of this application;
FIG. 3 is a schematic diagram of an A-A cross section of the thermoelectric cooler according to an embodiment of this application in FIG. 2;
FIG. 4 is a schematic diagram of another A-A cross section of the thermoelectric cooler according to an embodiment of this application in FIG. 2;
FIG. 5 is a flowchart of a method for preparing a thermoelectric cooler according to an embodiment of this application; and
FIG. 6 is another flowchart of a method for preparing a thermoelectric cooler according to an embodiment of this application.

### Reference numerals:

1: Monocrystalline silicon substrate; 11: First substrate;
12: Second substrate; 2: Conductive sheet;
21: Connection area; 3: Semiconductor thermoelectric particle;
31: P-type semiconductor thermoelectric particle; 32: N-type semiconductor thermoelectric particle;
4: Insulation layer; 5: Metallization layer; and
6: Solder layer.

### DESCRIPTION OF EMBODIMENTS

A thermoelectric cooler provided in this embodiment of this application may be applied to various electronic devices, and is configured to perform temperature control on a structure to be controlled by temperature in the electronic devices, so that a temperature of the structure to be controlled by temperature remains at a set temperature. Therefore, a working effect and reliability of the structure to be controlled by temperature can be improved. Costs of a thermoelectric cooler in the conventional technology are high, and costs of a substrate account for 20% to 30% of costs of preparing a high-performance thermoelectric cooler. Therefore, costs of the substrate can be reduced to reduce costs of preparing the thermoelectric cooler, and the substrate needs to remain a high thermal conductivity coefficient. Therefore, this application provides a thermoelectric cooler, a method for preparing a thermoelectric cooler, and an electronic device.

To make the objectives, technical solutions, and advantages of this application clearer, the following further describes this application in detail with reference to the accompanying drawings. The terms used in the following embodiments are merely for the purpose of describing specific embodiments, but are not intended to limit this application. As used in the specification and the appended claims of this application, the singular forms "one", "a", "the", "the foregoing", "the", and "this" are also intended to include, for example, "one or more", unless otherwise specified in the context.

Reference to "an embodiment", "some embodiments", or the like described in this specification indicates that one or more embodiments of this application include a specific feature, structure, or characteristic described with reference to the embodiments. Therefore, statements such as "in one embodiment", "in some embodiments", "in some other embodiments", and "in still some other embodiments" that appear as differences in this specification do not necessarily refer to a same embodiment, but mean "one or more but not all embodiments", unless otherwise specially emphasized in another manner. The terms "include", "contain", "have", and other variants thereof all mean "include but are not limited to", unless otherwise specifically emphasized.

The electronic device provided in embodiments of this application may include various terminal devices and electronic components. Specifically, the electronic device includes but is not limited to terminal devices such as a smartphone, a smart television, a smart television set-top box, a personal computer (personal computer, PC), a wearable device, and a smart broadband, telecommunications devices such as a wireless network, a fixed network, and a server, and electronic components such as a chip module and a memory. The terminal devices are not enumerated one by one herein. The electronic device includes a structure to be controlled by temperature. A substrate of the thermoelectric cooler is disposed in contact with the structure to be controlled by temperature, and is configured to perform temperature control on the structure to be controlled by temperature, so that the structure to be controlled by temperature remains working at a proper temperature. Therefore, a working effect and reliability of the structure to be controlled by temperature can be improved. Specifically, a specific type of the foregoing structure to be controlled by temperature is not limited. For example, the structure to be controlled by temperature may be a device that is sensitive to temperature, such as an optical component, an electrical component, a laser, or a modulator.

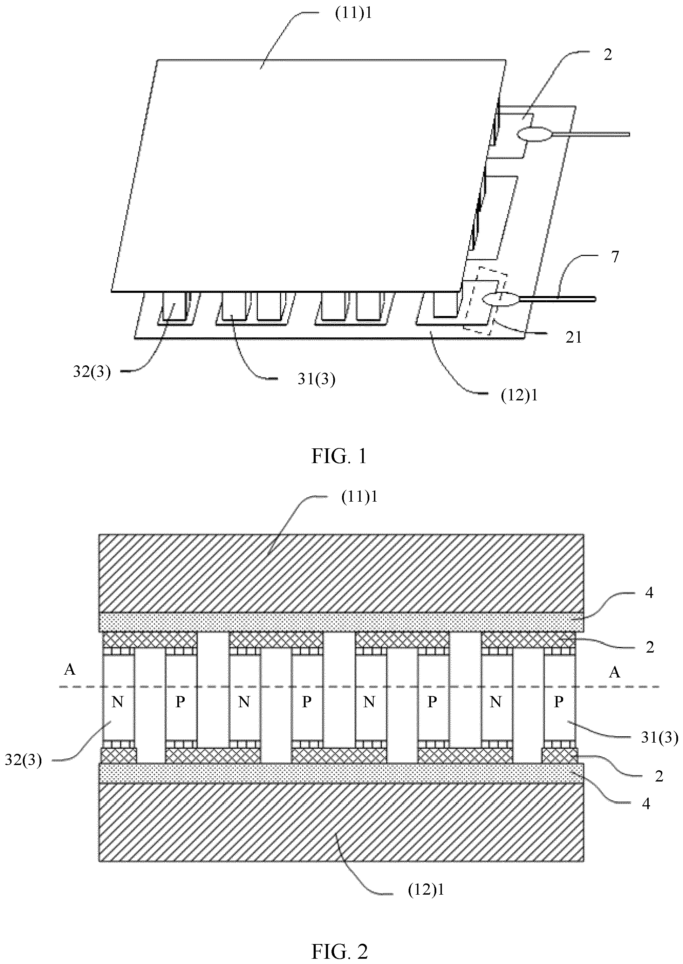

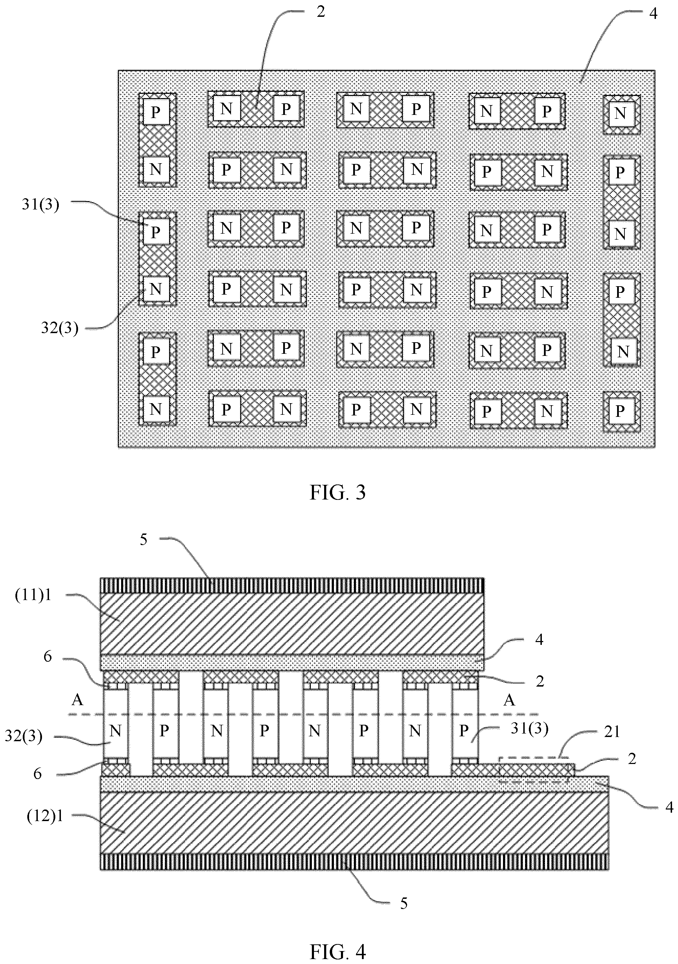

The electronic device includes a thermoelectric cooler. As shown in FIG. 1 and FIG. 2, FIG, 1 is a schematic diagram of a structure of a thermoelectric cooler according to an embodiment of this application, and FIG. 2 is a schematic diagram of a cross-section structure of a thermoelectric cooler according to an embodiment of this application. The thermoelectric cooler includes two monocrystalline silicon substrates 1 disposed opposite to each other, and there are a plurality of semiconductor thermoelectric particles 3 between the two monocrystalline silicon substrates 1. In a specific embodiment, the two monocrystalline silicon substrates 1 are disposed in parallel, or the two monocrystalline silicon substrates 1 are disposed roughly in parallel. An insulation layer 4 is provided on a side that is of the monocrystalline silicon substrate 1 and that faces the semiconductor thermoelectric particles 3. Refer to FIG. 2 and FIG. 3. FIG. 3 is a schematic diagram of an A-A cross section of the thermoelectric cooler according to an embodiment of this application in FIG. 2. The semiconductor thermoelectric particles 3 include P-type semiconductor thermoelectric particles 31 and N-type semiconductor thermoelectric particles 32. A conductive sheet 2 is disposed on a side that is of the insulation layer 4 and that faces the semiconductor thermoelectric particles 3. The P-type semiconductor thermoelectric particles 31 and the N-type semiconductor thermoelectric particles 32 are electrically connected in series with space by using the conductive sheet 2. Each conductive sheet 2 is connected to one end of one P-type semiconductor thermoelectric particle 31 and one end of one adjacent N-type semiconductor thermoelectric particle 32, so that the semiconductor thermoelectric particles 3 form a serial electrical connection structure. The semiconductor thermoelectric particles 3 have a thermoelectric effect, and may be specifically a bismuth telluride (BiTe) material. Therefore, after being powered on, the thermoelectric cooler implements a cooling function or a heating function by using the semiconductor thermoelectric particles 3. In this embodiment of this application, the monocrystalline silicon substrate 1 is used as a substrate of the thermoelectric cooler, and costs of the monocrystalline silicon substrate 1 are low. Therefore, preparation costs of the electronic device can be reduced.

Refer to Table 1. Table 1 is an analysis table, made by the inventor, of thermal conductivity coefficients of an aluminum nitride AlN ceramic substrate and a monocrystalline silicon Si substrate at different temperatures. Because the thermal conductivity coefficient of the monocrystalline silicon substrate 1 is about 80% to 90% of the thermal conductivity coefficient of the aluminum nitride ceramic substrate within a common cooling temperature range of 25°C to 100°C. It may be determined through calculation according to the Fourier's law of heat conduction that, except that substrate materials are different, when other conditions are the same, a difference between performance of the thermoelectric cooler in this embodiment of this application and performance of a technical solution using the aluminum nitride ceramic substrate in the conventional technology does not exceed 1%. The thermal conductivity coefficient refers to heat transferred through an area of 1 square meter in a specific period of time by using a material with a thickness of 1 meter (m) and a temperature difference of 1°C (K, °C) between surfaces of two sides under stable heat transfer conditions. The unit is Watt/m·Kelvin (W/m·K).

**Table 1 Analysis of thermal conductivity coefficients of aluminum nitride ceramic substrate and monocrystalline silicon substrate at different temperatures**

| | | | | | |
|---|---|---|---|---|---|
| Temperature (Celsius °C) | 25 | 40 | 60 | 80 | 100 |
| AlN thermal conductivity coefficient (Watt/meter Kelvin W/m·k) | 157 | 150 | 146 | 140 | 135 |
| Si thermal conductivity coefficient (Watt/meter Kelvin W/m·k) | 142 | 135 | 124 | 117 | 110 |
| Si/AIN thermal conductivity coefficient ratio (%) | 90.4 | 90.0 | 84.9 | 83.6 | 81.5 |

In addition, the inventor of this application further performs simulation analysis on a thermoelectric cooler with an aluminum nitride AlN ceramic substrate and a thermoelectric cooler with a monocrystalline silicon Si substrate. Refer to Table 2. Table 2 shows simulation results of the thermoelectric cooler with the aluminum nitride AlN ceramic substrate and the thermoelectric cooler with the monocrystalline silicon Si substrate. If cooling capacity and supply power are the same, temperature differences between two substrates of the thermoelectric cooler with the aluminum nitride AlN ceramic substrate and the thermoelectric cooler with the monocrystalline silicon Si substrate are 36.2°C and 36.5°C respectively, and a cooling coefficient difference is 0.0005. It may be learned that performance of the thermoelectric cooler in this embodiment of this application is very close to a cooling coefficient of a technical solution in the conventional technology in which an aluminum nitride ceramic substrate is used. Therefore, this solution can ensure a cooling effect of the thermoelectric cooler and reduce preparation costs.

**Table 2 Simulation analysis table of thermoelectric cooler with AlN substrate and thermoelectric cooler with Si substrate**

| | Si substrate TEC | AlN substrate TEC |
|---|---|---|
| Cooling capacity (Watt W) | 0.391 | 0.391 |
| Supply power (Watt W) | 0.409 | 0.409 |
| Temperature difference between two substrates (Celsius °C) | 36.2 | 36.5 |
| Cooling coefficient | 0.9558 | 0.9563 |

Refer to Table 3. The inventor further analyzes strengths of the AlN substrate and the Si substrate. For a specific analysis result, refer to Table 3. A compression strength of the monocrystalline silicon substrate 1 is basically the same as a compression strength of the aluminum nitride substrate. Compared with a bending strength of the aluminum nitride substrate, a bending strength of the monocrystalline silicon substrate 1 is less than 100 megapascals MPa, but the bending strength of the monocrystalline silicon substrate 1 can still meet a bending strength requirement of the thermoelectric cooler for the substrate. Therefore, the monocrystalline silicon substrate 1 can be used as a substrate of a thermoelectric cooler.

**Table 3 Strength comparison analysis between AlN substrate and Si substrate**

| | Bending strength (megapascal Mpa) | Compression Strength (megapascal Mpa) |
|---|---|---|
| AlN substrate | 400 | 2000 |
| Si substrate | 300 | 2000 |
| Si substrate/AlN substrate | 75% | 100% |

Refer to FIG. 2. The thermoelectric cooler includes two monocrystalline silicon substrates 1: a first substrate 11 and a second substrate 12. That the first substrate 11 generates heat and the second substrate 12 cools is used an example. Based on a principle of thermal expansion and cold contraction, a thermal expansion degree of the first substrate 11 is higher than a thermal expansion degree of the second substrate 12. Therefore, warping of the thermoelectric cooler in a direction toward the second substrate 12 occurs. In addition, when the substrate expands, the semiconductor thermoelectric particles 3 fastened on the monocrystalline silicon substrate 1 are subjected to a pulling force. Therefore, an electrical connection effect deteriorates. However, the structure to be controlled by temperature that uses the thermoelectric cooler needs to adhere to the substrate of the thermoelectric cooler. Therefore, a better temperature adjustment effect can be achieved. A thermal expansion coefficient is used to describe an extent to which an object expands or shrinks due to temperature changes. Specifically, the thermal expansion coefficient refers to a change in a length value caused by a change in a unit temperature of an object under equal pressure, and the unit is parts per million/Celsius (ppm/°C). Specifically, a thermal expansion coefficient of the monocrystalline silicon substrate 1 is 2.5 ppm/°C, and a thermal expansion coefficient of the aluminum nitride ceramic substrate is 4.7 ppm/°C. Therefore, the thermal expansion coefficient of the monocrystalline silicon substrate 1 is low, thermal expansion deformation caused by monocrystalline silicon substrate 1 is small, and a corresponding warping degree is low. Therefore, a working effect of the monocrystalline silicon substrate 1 can be improved, a pulling force of the semiconductor thermoelectric particles 3 can be reduced, electrical connection reliability of the semiconductor thermoelectric particles 3 can be improved, and reliability of the thermoelectric cooler can be improved.

When the monocrystalline silicon substrate 1 is specifically prepared, a size of the monocrystalline silicon substrate 1 is not specifically limited. For example, a length and a width of the monocrystalline silicon substrate 1 may be 1 mm to 20 mm, and a thickness may be 0.1 mm to 0.6 mm. The specific size may be designed based on product requirements. Specifically, when the monocrystalline silicon substrate 1 is prepared, a silicon wafer may be used as a raw material, for example, an 8-inch silicon wafer or 12-inch silicon wafer is commonly used, and the silicon wafer is processed into a monocrystalline silicon substrate 1 of a required size through mechanical cutting or laser cutting.

When the insulation layer 4 is prepared, the insulation layer 4 may be a silicon dioxide film or a silicon nitride film, so that a preparation process of the insulation layer 4 is close to a preparation process of the monocrystalline silicon substrate 1, to simplify a preparation process and costs. In addition, the silicon dioxide film or the silicon nitride film is easy to obtain, and costs are low. In addition, the silicon dioxide film or the silicon nitride film includes silicon, and an adhesive force between the silicon dioxide film or the silicon nitride film and the monocrystalline silicon substrate 1 is good. This helps improve reliability of adhesion between the insulation layer 4 and the monocrystalline silicon substrate 1. A thermal conductivity coefficient of the silicon dioxide film is about 1.1 W/m. K, and a thermal conductivity coefficient of the silicon nitride film is about 10 to 43 W/m. K. Specifically, the silicon dioxide film may be prepared by using a process of a thermal oxidation (Thermal Oxidation, THOX) method, a chemical vapor deposition (Chemical Vapor Deposition, CVD) method, or a physical vapor deposition (Physical Vapor Deposition, PVD) method. The foregoing silicon nitride film may be prepared by using a CVD or PVD process.

In this embodiment of this application, a thickness M of the insulation layer 4 may meet: 0.1 µm ≤ M ≤ 1 µm, and the thickness of the insulation layer 4 is at least 0.1 µm. In this way, the insulation layer 4 has an effective insulation effect, and a reliable insulation connection is implemented between the monocrystalline silicon substrate 1 and the conductive sheet 2, and a current is prevented from entering the monocrystalline silicon substrate 1. Therefore, power supplies can be reduced, resistance can be reduced, and a good working effect of the thermoelectric cooler can be achieved. The thickness of the insulation layer 4 does not exceed 1 µm, and thermal resistance of the insulation layer 4 is low. Therefore, this facilitates temperature conduction through the insulation layer 4, and improves working efficiency of the thermoelectric cooler.

Refer to FIG. 4. FIG. 4 is a schematic diagram of another A-A cross section of the thermoelectric cooler according to an embodiment of this application in FIG. 2. The conductive sheets 2 in this embodiment of this application implement serial electrical connection of the semiconductor thermoelectric particles 3. In addition, the conductive sheets 2 are further configured to connect the semiconductor thermoelectric particles 3 to a circuit. Specifically, a connection area 21 may be reserved on two conductive sheets 2 at an edge of the serial circuit, to bond a conductor 7 in the reserved connection area 21. Specifically, the conductive sheets 2 may be a multi-layer metal structure. The multi-layer metal structure may include a titanium layer, a copper layer, a nickel layer, and a gold layer that are sequentially disposed in a direction away from the monocrystalline silicon substrate 1. Alternatively, the multi-layer metal structure may include a copper layer, a nickel layer, and a gold layer that are sequentially disposed in a direction away from the monocrystalline silicon substrate 1. Alternatively, the multi-layer metal structure may include a titanium layer, a copper layer, and a nickel layer that are sequentially disposed in a direction away from the monocrystalline silicon substrate 1. Specifically, the foregoing metal layers may be prepared by using an electroplating process. The copper layer is a main conducting layer, and a thickness of the copper layer is at least 10 µm, and the conductive sheet has a good flow guiding effect. The foregoing metal layers may be prepared by using an electroplating process.

Refer to FIG. 1 and FIG. 4. A metallization layer 5 is further provided on a side that is of the monocrystalline silicon substrate 1 and that faces away from the semiconductor thermoelectric particles 3, to improve reliability of a connection between the monocrystalline silicon substrate 1 and the structure to be controlled by temperature. Specifically, the metallization layer 5 has good adhesion. Therefore, this helps improve tightness of adhesion between the monocrystalline silicon substrate 1 and the structure to be controlled by temperature, and improves a working effect of the thermoelectric cooler.

The metallization layer 5 may include a multi-layer metal structure. The multi-layer metal structure may include a titanium layer, a copper layer, a nickel layer, and a gold layer that are sequentially disposed in a direction away from the monocrystalline silicon substrate 1. Alternatively, the multi-layer metal structure may include a copper layer, a nickel layer, and a gold layer that are sequentially disposed in a direction away from the monocrystalline silicon substrate 1. Alternatively, the multi-layer metal structure may include a titanium layer, a nickel layer, and a gold layer that are sequentially disposed in a direction away from the monocrystalline silicon substrate 1. Specifically, the foregoing metal layers may be prepared by using an electroplating process. The copper layer or the titanium layer may be used as a seed layer, to improve reliability of fastening the metallization layer 5 and the monocrystalline silicon substrate 1. The nickel layer is a barrier layer, and is configured to prevent electron mobility. The gold layer is a protection layer. The gold layer protects the metal layer between the gold layer and the monocrystalline silicon substrate 1 to reduce a loss caused by oxidation or the like. In addition, the gold layer facilitates adhesion to the structure to be controlled by temperature.

In a specific embodiment, a metal layer structure of the metallization layer may be the same as a metal layer structure of the conducting layer, so that both the metal layer structure of the metallization layer and the metal layer structure of the conducting layer may be prepared by using an electroplating process, to simplify a preparation process of the thermoelectric cooler.

Refer to FIG. 4. There is a solder layer 6 between the conductive sheets 2 and the semiconductor thermoelectric particles 3, that is, the conductive sheets 2 are electrically connected to the semiconductor thermoelectric particles 3 through welding. In this solution, an electrical connection and a fixed connection between the conductive sheets 2 and the semiconductor thermoelectric particles 3 are implemented in a welding manner. Connection reliability is high. In addition, the conductive sheets 2 and the semiconductor thermoelectric particles 3 are connected by using the solder layer 6, and thermal resistance is low. Therefore, heat conduction efficiency can be improved, and a working effect of the thermoelectric cooler can be improved.

Specifically, when the solder layer 6 is selected, tin-gold (AuSn) solder or tin-antimony (SnSb) solder may be selected. The foregoing two types of solder have a good melting point, and therefore reliability of the welding connection is high.

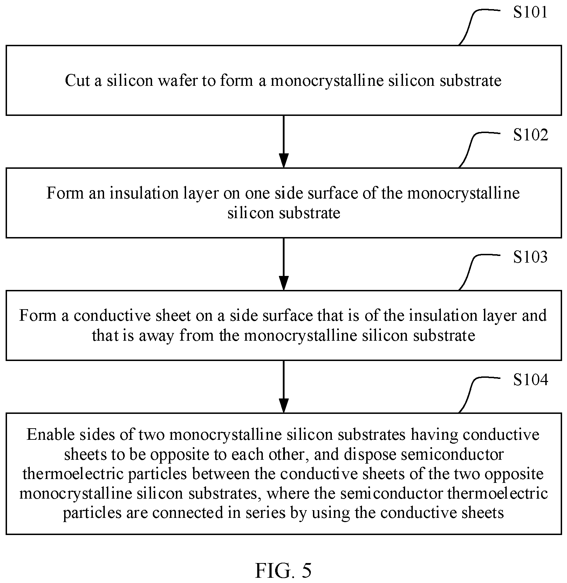

Based on a same inventive idea, this application further provides a method for preparing a thermoelectric cooler, and the method is used to prepare the thermoelectric cooler in any one of the foregoing technical solutions. Refer to FIG. 5. FIG. 5 is a flowchart of a method for preparing a thermoelectric cooler according to an embodiment of this application. The method for preparing the thermoelectric cooler specifically includes the following steps.

Step S101: Cut a silicon wafer to form a monocrystalline silicon substrate.

Specifically, when the silicon wafer is cut, the silicon wafer may be cut in a mechanical cutting manner or a laser cutting manner to form the monocrystalline silicon substrate. Specifically, a length and width of the monocrystalline silicon substrate may be 1 mm to 20 mm, and a thickness may be 0.1 mm to 0.6 mm.

Step S102: Form an insulation layer on one side surface of the monocrystalline silicon substrate.

A thickness M of the insulation layer may meet: 0.1 µm ≤ M ≤ 1 µm, and the thickness of the insulation layer is at least 0.1 µm. In this way, the insulation layer has an effective insulation effect, a reliable insulation connection may be implemented between the monocrystalline silicon substrate and the conductive sheet, and a current is prevented from entering the monocrystalline silicon substrate. Therefore, power supplies can be reduced, resistance can be reduced, and a good working effect of the thermoelectric cooler can be achieved. If the thickness of the insulation layer does not exceed 1 µm, thermal resistance of the insulation layer is low. Therefore, this facilitates temperature conduction through the insulation layer, and improves working efficiency of the thermoelectric cooler.

A material of the insulation layer is not limited, and may be a silicon dioxide film or a silicon nitride film, so that a preparation process of the insulation layer is close to a preparation process of the monocrystalline silicon substrate, to simplify a preparation process and costs. In addition, the silicon dioxide film or the silicon nitride film is easy to obtain, and costs are low. In addition, the silicon dioxide film or the silicon nitride film includes silicon, and an adhesive force between the silicon dioxide film or the silicon nitride film and the monocrystalline silicon substrate is good. This helps improve reliability of adhesion between the insulation layer and the monocrystalline silicon substrate.

Specifically, the silicon dioxide film may be prepared by using a process of a thermal oxidation (Thermal Oxidation, THOX) method, a chemical vapor deposition (Chemical Vapor Deposition, CVD) method, or a physical vapor deposition (Physical Vapor Deposition, PVD) method. The foregoing silicon nitride film may be prepared by using a CVD or PVD process.

Step S103: Form a conductive sheet on one side surface that is of the insulation layer and that is away from the monocrystalline silicon substrate.

The conductive sheet may be a multi-layer metal structure. The multi-layer metal structure may include a titanium layer, a copper layer, a nickel layer, and a gold layer that are sequentially disposed in a direction away from the monocrystalline silicon substrate. Alternatively, the multi-layer metal structure may include a copper layer, a nickel layer, and a gold layer that are sequentially disposed in a direction away from the monocrystalline silicon substrate. Alternatively, the multi-layer metal structure may include a titanium layer, a copper layer, and a nickel layer that are sequentially disposed in a direction away from the monocrystalline silicon substrate. Specifically, the foregoing metal layers may be sequentially prepared by using an electroplating process.

Step S104: Enable sides of two monocrystalline silicon substrates having conductive sheets to be opposite to each other, and dispose semiconductor thermoelectric particles between the conductive sheets of the two opposite monocrystalline silicon substrates, where the semiconductor thermoelectric particles are connected in series by using the conductive sheets.

Specifically, the conductive sheets may be electrically connected to the semiconductor thermoelectric particles through welding. In this solution, reliability of the connection between the conductive sheets and the semiconductor thermoelectric particles is high. In addition, the conductive sheets and the semiconductor thermoelectric particles are connected by using the solder layer, and thermal resistance is low. Therefore, heat conduction efficiency can be improved, and a working effect of the thermoelectric cooler can be improved.

In this solution, in the thermoelectric cooler prepared by using the foregoing preparation method, the monocrystalline silicon substrate is used as a substrate of the thermoelectric cooler, and costs of the monocrystalline silicon substrate are low. Therefore, preparation costs of the electronic device can be reduced. In addition, a thermal expansion coefficient of the monocrystalline silicon substrate is low, thermal expansion deformation caused when the monocrystalline silicon substrate is heated is small, and a corresponding warping degree is also low. Therefore, a working effect of the thermoelectric cooler can be improved, a pulling force of the substrate on semiconductor thermoelectric particles can be reduced, reliability of an electrical connection of the semiconductor thermoelectric particles can be improved, and reliability of the thermoelectric cooler can be improved.

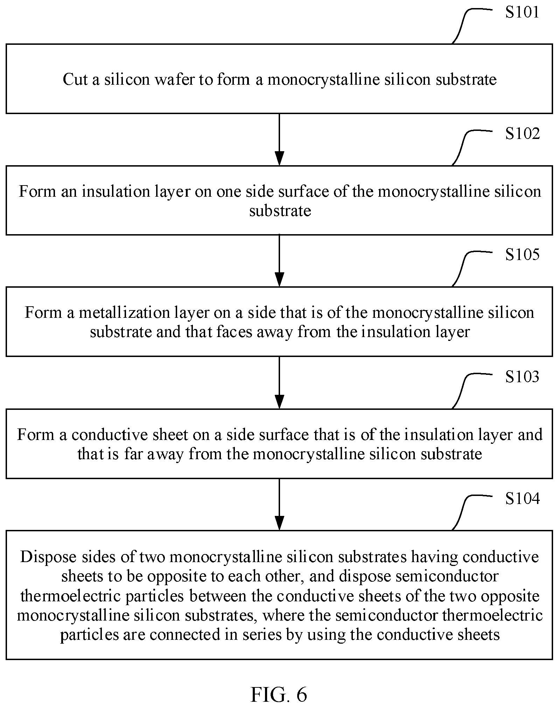

Refer to FIG. 6. FIG. 6 is another flowchart of a method for preparing a thermoelectric cooler according to an embodiment of this application. After step S102, the method further includes step S105: forming a metallization layer on a side that is of the monocrystalline silicon substrate and that faces away from the insulation layer.

The metallization layer may improve reliability of a connection between the monocrystalline silicon substrate and the structure to be controlled by temperature. Specifically, the metallization layer has good adhesion. Therefore, this helps improve tightness of adhesion between the monocrystalline silicon substrate and the structure to be controlled by temperature, and improves a working effect of the thermoelectric cooler.

Specifically, a metal layer structure of the metallization layer may be the same as a metal layer structure of the conductive sheet, so that two sides of the monocrystalline silicon substrate having the insulation layer are electroplated once to form the metallization layer and the conductive sheet, to simplify a preparation process of the thermoelectric cooler. Specifically, when the conductive sheets are prepared, a pattern of the conductive sheets may be formed by disposing a barrier layer, to directly form the conductive sheets through electroplating; or an entire metal layer may be electroplated, and then the conductive sheets are formed by using an etching process. This is not specifically limited in this application.

The foregoing description is merely specific embodiments of this application, but is not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A thermoelectric cooler, comprising two monocrystalline silicon substrates disposed opposite to each other and semiconductor thermoelectric particles located between the two monocrystalline silicon substrates, and an insulation layer is provided on a side that is of a monocrystalline silicon substrate and that faces the semiconductor thermoelectric particles; and a conductive sheet is provided between the insulation layer and the semiconductor thermoelectric particles, and the conductive sheet is electrically connected to the semiconductor thermoelectric particles.

2. The thermoelectric cooler according to claim 1, wherein the insulation layer comprises a silicon dioxide film or a silicon nitride film.

3. The thermoelectric cooler according to claim 2, wherein the insulation layer is the silicon dioxide film, and the silicon dioxide film is prepared by using a thermal oxidation method, a chemical vapor deposition method, or a physical vapor deposition method; or
the insulation layer is the silicon nitride film, and the silicon nitride film is prepared by using a chemical vapor deposition method or a physical vapor deposition method.

4. The thermoelectric cooler according to any one of claims 1 to 3, wherein a thickness M of the insulation layer meets: 0.1 ≤ M ≤ 1 µm.

5. The thermoelectric cooler according to any one of claims 1 to 4, wherein a metallization layer is provided on a side that is of the monocrystalline silicon substrate and that faces away from the semiconductor thermoelectric particles.

6. The thermoelectric cooler according to claim 5, wherein a metal layer structure of the metallization layer is the same as a metal layer structure of the conductive sheet.

7. The thermoelectric cooler according to claim 5, wherein the metallization layer comprises a titanium layer, a copper layer, a nickel layer, and a gold layer that are sequentially disposed in a direction away from the monocrystalline silicon substrate;
the metallization layer comprises a copper layer, a nickel layer, and a gold layer that are sequentially disposed in a direction away from the monocrystalline silicon substrate; or
the metallization layer comprises a titanium layer, a nickel layer, and a gold layer that are sequentially disposed in a direction away from the monocrystalline silicon substrate.

8. The thermoelectric cooler according to any one of claims 1 to 7, wherein the semiconductor thermoelectric particles are welded to the conductive sheet.

9. An electronic device, comprising a structure to be controlled by temperature and the thermoelectric cooler according to any one of claims 1 to 8, wherein the thermoelectric cooler performs temperature control on the structure to be controlled by temperature.

10. The electronic device according to claim 9, wherein the structure to be controlled by temperature comprises an optical component, an electrical component, a laser, or a modulator.

11. A method for preparing a thermoelectric cooler, comprising:
cutting a silicon wafer to form a monocrystalline silicon substrate;
forming an insulation layer on one side surface of the monocrystalline silicon substrate;
forming a conductive sheet on one side surface that is of the insulation layer and that is away from the monocrystalline silicon substrate; and
enabling sides of two monocrystalline silicon substrates having conductive sheets to be opposite to each other, and disposing semiconductor thermoelectric particles between the conductive sheets of the two opposite monocrystalline silicon substrates, wherein the semiconductor thermoelectric particles are connected in series by using the conductive sheets.

12. The method for preparing a thermoelectric cooler according to claim 11, wherein the forming an insulation layer on one side surface of a monocrystalline silicon substrate comprises:
if the insulation layer is a silicon dioxide film, preparing the silicon dioxide film by using a thermal oxidation method, a chemical vapor deposition method, or a physical vapor deposition method; or
if the insulation layer is a silicon nitride film, preparing the silicon nitride film by using a chemical vapor deposition method or a physical vapor deposition method.

13. The method for preparing a thermoelectric cooler according to claim 11 or 12, wherein after the forming an insulation layer on one side surface of a monocrystalline silicon substrate, the method comprises:
forming a metallization layer on a side that is of the monocrystalline silicon substrate and that faces away from the insulation layer.

14. The method for preparing a thermoelectric cooler according to claim 13, wherein two sides of the monocrystalline silicon substrate having the insulation layer are electroplated once to form the metallization layer and the conductive sheet.

15. The method for preparing a thermoelectric cooler according to any one of claims 11 to 14, wherein the semiconductor thermoelectric particles are welded to the conductive sheet.
